# EUROPEAN PATENT APPLICATION

(11) **EP 3 823 009 A1**
(43) Date of publication of application: **19.05.2021**
(21) Application number: 18926337.9
(22) Date of filing: 10.07.2018
(51) Int. Cl.: H01L 21/56

(54) **METHOD OF MANUFACTURING MOLD BODY AND PACKAGE AND DEVICE FOR MANUFACTURING MOLD BODY**

(71) Applicant: Fuji Corporation, Chiryu-shi, Aichi 472-8686 (JP)
(72) Inventor: KUSUNOKI Kazuhiro, Chiryu-shi, Aichi 472-8686 (JP)
(74) Representative: Grünecker Patent- und Rechtsanwälte PartG mbB
(86) International application number: PCT/JP2018/026082
(87) International publication number: WO 2020/012567

(57) **Abstract**

According to a method of manufacturing a mold body, the mold body including a support, a chip disposed at a first position preset on the support, and a molding material covering a periphery of the chip is manufactured. The method of manufacturing a mold body includes a disposition step of disposing the chip at a second position set on the support and a molding step of molding the periphery of the chip disposed on the support in the disposition step with the molding material. In the molding step, the chip disposed at the second position is moved to the first position by a flow pressure of the molding material.

## Description

### Technical Field

A technique disclosed in the present specification relates to a technique of manufacturing a package including a chip. In particular, the present specification relates to a technique of manufacturing a package and a mold body which is an intermediate product of the package.

### Background Art

When a package including a chip is manufactured, the chip may be sealed in the package by covering a periphery of a chip with a molding material. For example, JP-A-9-148479 discloses a resin sealing type package. In the package described in JP-A-9-148479, in an assembly step of the package, the chip is sealed by pressure-injecting a resin into a mold. Further, the chip and a wiring component are joined to each other by heating and pressurization. In this case, a position of the wiring component with respect to the chip may deviate from a predetermined position due to a difference in a thermal expansion amount between an insulating substrate which is a base of the wiring component and the chip. In the package described in JP-A-9-148479, the wiring component is disposed at a position corrected by a positional deviation amount in advance in consideration of the thermal expansion amount caused by heating at the time of the joining.

### Summary of the Invention

### Technical Problem

When a chip deviates from a predetermined disposition position with respect to a wiring component at the time of manufacturing, the chip and the wiring component cannot be properly connected to each other, and thus, these are discarded, and a problem that a yield is reduced occurs. Therefore, in the package of JP-A-9-148479, the wiring component is disposed at a position corrected by a positional deviation amount in advance in consideration of the thermal expansion amount at the time of the joining. However, in the manufacture of the package, the chip may be deviated from a mounting position due to the pressurization from the resin when sealing the chip with the resin. Thus, there is a problem that the positional deviation between the chip and the wiring component is caused not only by thermal expansion due to the heating but also by pressurization during molding. The present specification discloses a technique for accurately disposing a chip to be sealed in a package at a predetermined position.

### Solution to Problem

In a method of manufacturing a mold body disclosed in the present specification, the mold body including a support, a chip disposed at a first position preset on the support, and a molding material covering a periphery of the chip is manufactured. The method of manufacturing a mold body includes a disposition step of disposing the chip at a second position set on the support and a molding step of molding the periphery of the chip disposed on the support in the disposition step with the molding material. In the molding step, the chip disposed at the second position is moved to the first position by a flow pressure of the molding material.

In the method of manufacturing a mold body, the chip disposed at the second position in the disposition step is moved to the first position preset on the support in the molding step. That is, in the molding step, the chip disposed on the support is moved from the second position to the first position by a flow pressure of the molding material. In the disposition step, by disposing the chip at the second position considering a movement amount at the time of the molding step, the chip is moved to the first position during the molding step. Accordingly, the chip after the molding step can be disposed at a predetermined position (that is, a first position). By manufacturing a package from this mold body, a package can be manufactured with a high yield.

Moreover, a method of manufacturing a package disclosed in the present specification includes a peeling step of peeling the support from the mold body and a wiring layer forming step of forming a wiring layer connected to the chip after the peeling step.

In the method of manufacturing a package, a package is manufactured using the mold body manufactured using the manufacturing method. Therefore, it is possible to provide the same operation and effect as in the method of manufacturing a mold body.

Moreover, a device for manufacturing a mold body disclosed in the present specification manufactures a mold body including a support, a chip disposed at a first position preset on the support, and a molding material covering a periphery of the chip. The device for manufacturing a mold body includes a chip disposition section configured to dispose the chip on the support, a molding section configured to mold the periphery of the chip disposed on the support with the molding material, a position measurement section configured to measure a position of the chip on the support after molding is performed by the molding section, and a position adjustment section configured to adjust a disposition position at which the chip is disposed by the chip disposition section so that the position of the chip after the molding is performed by the molding section becomes the first position, based on a positional deviation amount between a position of the chip before the molding is performed by the molding section and the position of the chip after the molding is performed by the molding section.

In the mold body manufacturing device, the position of the chip after the molding is performed is measured by the position measurement section. Accordingly it is possible to calculate the positional deviation amount of the chip due to the flow pressure of the molding material during the molding. Further, based on the calculated positional deviation amount, the position adjustment section can adjust the disposition position of the chip so that the chip after the molding is performed disposed at the first position. Therefore, it is possible to manufacture the mold body in which the chip is accurately disposed at the first position. Therefore, it is possible to provide the same operation and effect as in the method of manufacturing a mold body.

### Brief Description of Drawings

Fig. 1 is a cross-sectional view schematically illustrating a configuration of a package according to an embodiment.
Fig. 2 is a cross-sectional view illustrating a schematic configuration of a manufacturing step of the package according to the embodiment.
Fig. 3 is a diagram illustrating a schematic configuration of a package manufacturing device.
Fig. 4 is a flowchart illustrating an example of processing of calculating a positional deviation amount of the chip.
Fig. 5 is a diagram for explaining that a chip is moved by a flow pressure of a resin.
Fig. 6 is a flowchart illustrating an example of a manufacturing step of the package.
Fig. 7 is a diagram for explaining that the chip disposed at a second position is located at a first position after a molding step.

### Description of Embodiments

Main features of an embodiment described below are listed. Technical elements described below are independent technical elements, exhibit technical usefulness alone or by various combinations, and are not limited to combinations described in Claims when filing.

A method of manufacturing a mold body disclosed in the present specification may include a pre-disposition step of disposing a chip at a first position on a support before a disposition step, a pre-molding step of molding a periphery of the chip disposed at the first position in the pre-disposition step with a molding material, and a measurement step of measuring a position of the chip on the support after the pre-molding step. The second position may be set based on a positional deviation amount between the position of the chip measured in the measurement step and the first position. With such a configuration, it is possible to accurately calculate the positional deviation amount of the chip due to a flow pressure of the molding material from a difference between the position of the chip measured in the measurement step and the first position. Therefore, by setting the second position based on the calculated positional deviation amount, it is possible to accurately dispose the chip at the first position after the molding step.

In the method of manufacturing a mold body disclosed in the present specification, the mold body may include the support, multiple chips which are disposed on the support, and the molding material which covers peripheries of the multiple chips. The first position and the second position may be individually set for each of the multiple chips. With such a configuration, in a package including the multiple chips, disposition positions of the chips, that is, the first position and the second position, are individually set. In the package including the multiple chips, the flow pressure of the molding material at the time of the molding step applied to each chip differs depending on the position of the chip on the support, a position at which the molding material is injected, or the like. Therefore, by individually setting the first position and the second position for each chip, it is possible to accurately dispose each of the multiple chips at the first position after the molding step. As a result, all the chips can be disposed at predetermined positions after the molding step, and a package can be manufactured with a high yield.

### Embodiment

Hereinafter, a method of manufacturing package 50 according to an embodiment will be described. First, package 50 manufactured in the present embodiment and mold body 60 which is an intermediate product thereof will be described.

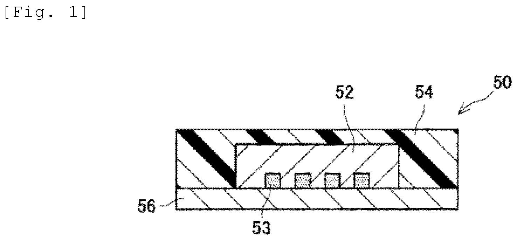

Fig. 1 schematically illustrates a configuration of package 50. As illustrated in Fig. 1, package 50 includes chip 52, molding material 54, and wiring layer 56. In the present embodiment, package 50 is a Fan-Out Wafer Level Package (FOWLP) or a Fan-Out Panel Level Package (FOPLP).

Chip 52 has a flat plate shape and includes multiple electrode pads 53 on one surface. In chip 52, the surface on which electrode pads 53 are formed abuts on wiring layer 56, and other surfaces are covered with molding material 54. Wiring layer 56 includes a wire or a bump (not illustrated) (hereinafter, simply referred to as a "wire") which is formed to electrically connect to each of electrode pads 53. When package 50 is mounted on a circuit board or the like, wiring layer 56 is disposed so as to abut on the circuit board or the like.

Next, mold body 60 which is the intermediate product of package 50 will be described. Here, in order to explain mold body 60, an outline of a manufacturing step of package 50 will also be described.

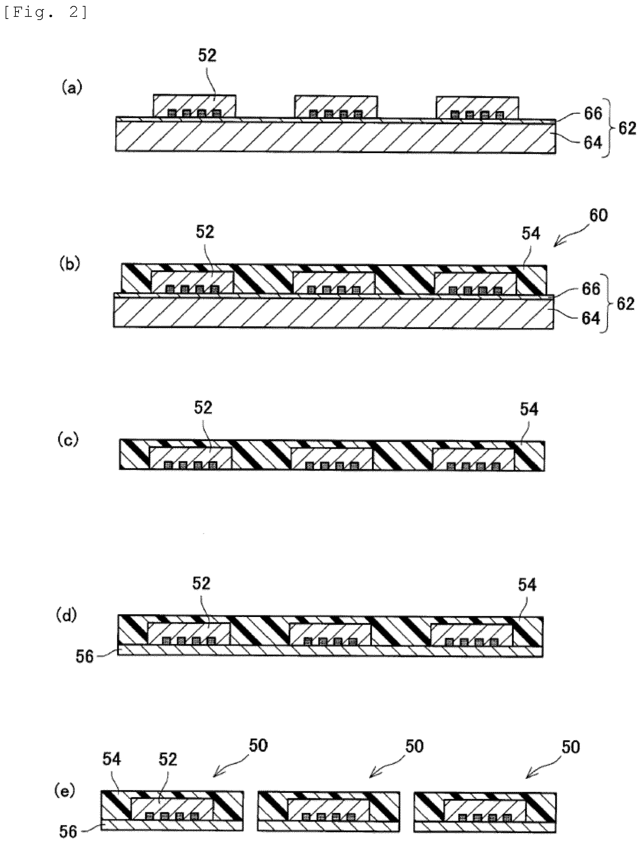

Fig. 2 schematically illustrates the manufacturing step of package 50. As illustrated in Fig. 2(a), first, multiple chips 52 are placed on support 62. Support 62 is composed of glass plate 64 and adhesive tape 66 which is adhered to a surface of glass plate 64 In adhesive tape 66, an adhesive is applied on both surfaces thereof, one surface is adhered to a surface of glass plate 64, and chips 52 are adhered to the other surface. When chips 52 are placed on support 62 (that is, adhesive tape 66), chips 52 are fixed at positions placed by adhesive tape 66. Multiple chips 52 are respectively fixed at predetermined positions on one support 62.

Next, as illustrated in Fig. 2(b), a periphery of each chip 52 is covered with molding material 54. In the present embodiment, the intermediate product in this state, that is, in a state in which multiple chips 52 are disposed on support 62 and the peripheries of multiple chips 52 are covered with molding material 54 is referred to as "mold body 60". In other words, mold body 60 includes one support 62, multiple chips 52 which abut on support 62, and molding material 54 which covers each of multiple chips 52.

Next, as illustrated in Fig. 2(c), support 62 is peeled from mold body 60. Then, chip 52 (specifically, the surface on which electrode pad 53 of chip 52 is formed) is exposed. Next, as illustrated in Fig. 2 (d), wiring layer 56 is formed on the surface to which each chip 52 is exposed. Then, as illustrated in Fig. 2 (e), die-cutting (fragmentation) is performed to obtain a structure constituted by chip 52, molding material 54, and wiring layer 56 so as to include individual chips 52. In this manner, multiple packages 50 are manufactured at once.

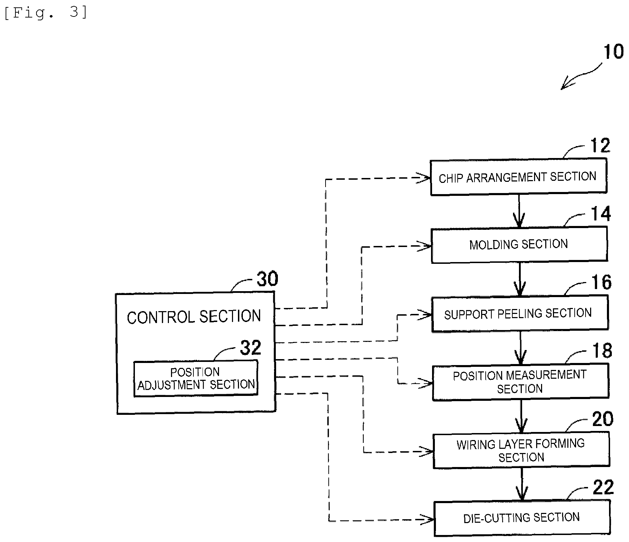

Next, package manufacturing device 10 for manufacturing package 50 will be described. As illustrated in Fig. 3, package manufacturing device 10 includes a chip disposition section 12, a molding section 14, a support peeling section 16, a position measurement section 18, a wiring layer forming section 20, a die-cutting section 22, and a control section 30. Each of sections 12, 14, 16, 18, 20, 22, and 30 may be an independent device or may be included in one device. In addition, only some of sections 12,14,16,18,20,22,30 may be configured as a combined device. In the present embodiment, regardless of whether each of sections 12, 14, 16, 18, 20, 22, and 30 is constituted by multiple devices or one device, production facilities including all of them are collectively referred to as "manufacturing devices".

Chip disposition section 12 is configured to dispose chip 52 on support 62. More specifically, chip disposition section 12 disposes multiple chips 52 at the set positions on support 62. The position of chip 52 disposed by chip disposition section 12 is controlled by control section 30. That is, chip disposition section 12 disposes chip 52 on support 62, based on the information on the disposition position of chip 52 transmitted from control section 30. Chip disposition section 12 can use a chip disposition section used in a known package manufacturing device, and thus, a detailed description of a configuration thereof is omitted. As described above, adhesive tape 66 is adhered to surface of support 62 Therefore, when chip 52 is disposed on support 62 by chip disposition section 12, chip 52 is fixed to support 62 by adhesive tape 66 (refer to Fig. 2(a)).

Molding section 14 is configured to cover the periphery of each of multiple chips 52 disposed on support 62 with molding material 54. Molding section 14 can be configured to include a mold which covers one surface of support 62, an injection device which injects molding material 54 into the mold, or the like. Molding section 14 can use a molding section used in a known package manufacturing device, and thus, a detailed description of a configuration thereof is omitted. A specific procedure for covering the periphery of each of multiple chips 52 disposed on support 62 with molding material 54 will be described below.

First, support 62 in which chip 52 is disposed on support 62 in chip disposition section 12 is carried in molding section 14. Next, molding section 14 molds molding material 54 on carried-in support 62. As a resin used for molding material 54, for example, a thermoplastic resin is used, but a type of the resin is not particularly limited and can be appropriately selected according to a type of package 50. Specifically, first, molding section 14 disposes a mold having a recessed section on support 62. Specifically, molding section 14 installs the mold so as to cover multiple chips 52 by the recessed section. Next, molding section 14 molds multiple chips 52 by injecting molten molding material 54 into the mold. In this case, pressure from the molten resin injected into the mold acts on chip 52 disposed on support 62. As described above, chip 52 is fixed on support 62 by adhesive tape 66. However, when a flow pressure of the resin injected into the mold is larger than an adhesive force of adhesive tape 66, chip 52 moves from the position disposed in chip disposition section 12 in accordance with the flow pressure when the resin spreads into a cavity of the mold. Mold body 60 including support 62, chip 52, and molding material 54 is formed by chip disposition section 12 and molding section 14 (refer to Fig. 2(b)).

Support peeling section 16 is configured to peel support 62 from mold body 60. Specifically, support peeling section 16 reduces the adhesive force of adhesive tape 66 adhering to chip 52, molding material 54, and support 62 to peel support 62 from mold body 60. Support peeling section 16 can a support peeling section used in a known package manufacturing device can be used, and thus, a detailed description of a configuration thereof is omitted. Further, a method of reducing the adhesive force of adhesive tape 66 is not particularly limited. Hereinafter, a composite of multiple chips 52 and molding material 54 in a state in which support 62 is peeled from mold body 60 may be referred to as a "chip composite". Chip 52 (more specifically, surface on which electrode pads 53 of each chip 52 are formed) is exposed to one surface of the chip composite (refer to Fig. 2(c)).

Position measurement section 18 is configured to measure the position of chip 52 in the chip composite. Specifically, position measurement section 18 includes a camera (not illustrated), and measures the position of chip 52 as follows using the camera. First, position measurement section 18 inverts the chip composite up and down so that the surface of the chip composite in which chip 52 is exposed faces upward. Next, position measurement section 18 photographs the surface of the chip composite in which chip 52 is exposed from above to below using a camera. The camera may be installed so as to photograph from below to above so that the chip composite is photographed from below without inverting the chip composite up and down. The captured image is transmitted to Control section 30. Control section 30 calculates the position of each chip 52 in the image by analyzing the captured image.

Wiring layer forming section 20 is configured to form wiring layer 56 in the chip composite. Specifically, wiring layer forming section 20 forms wiring layer 56 on the surface of the chip composite in which chip 52 is exposed (refer to Fig. 2 (d)). Wiring layer forming section 20 forms wiring layer 56 so that wiring layer 56 is electrically connected to each electrode pad 53 of chip 52 when chip 52 is disposed at a predetermined position in the chip composite. That is, the wire formed by wiring layer forming section 20 is designed on an assumption that chip 52 is disposed at a predetermined position in the chip composite. Therefore, in a case where the position of chip 52 in the chip composite is deviated, even if wiring layer 56 is formed, chip 52 and wiring layer 56 may not be electrically connected to each other.

Die-cutting section 22 is configured to divide a structure in which wiring layer 56 is formed in the chip composite by wiring layer forming section 20 into individual packages 50. Specifically, die-cutting section 22 performs division (fragmentation) so that individual chips 52 are included in individual packages 50 (refer to Fig. 2(e)). Wiring layer forming section 20 and die-cutting section 22 can use a wiring layer forming section and a die-cutting section used in a known package manufacturing device, and thus, detailed descriptions of configurations thereof are omitted.

For example, control section 30 can be constituted by a computer including CPU, ROM, a RAM, or the like. When the computer executes the program, control section 30 functions as position adjustment section 32 or the like illustrated in Fig. 3. Processing executed by control section 30 will be described in detail later. Further, control section 30 is connected to chip disposition section 12, molding section 14, support peeling section 16, position measurement section 18, wiring layer forming section 20, and die-cutting section 22, and controls respective sections 12, 14, 16, 18, 20, and 22.

Next, a method of manufacturing package 50 will be described in detail. As described above, in a process of manufacturing package 50, mold body 60 which is the intermediate product is manufactured. Mold body 60 is manufactured by disposing chip 52 on support 62 and then performing molding so as to cover the periphery of chip 52 with molding material 54. However, the position of chip 52 in mold body 60 may be deviated by the flow pressure of molding material 54 at the time of the molding. If the position of chip 52 in mold body 60 is deviated, when wiring layer 56 is formed in the subsequent manufacturing step, the position of the wire in wiring layer 56 is deviated with respect to chip 52, and thus, chip 52 and the wire is not electrically connected to each other. In the present embodiment, chip 52 after the molding step so as to be positioned at a desired position (hereinafter, this position may also be referred to as a "first position") to adjust the position of chip 52 when disposing chip 52 on support 62.

Before package 50 is manufactured, in order to calculate a positional deviation amount of chip 52 due to the molding step, positional deviation amount calculation processing is performed. Hereinafter, the positional deviation amount calculation processing will be described in detail.

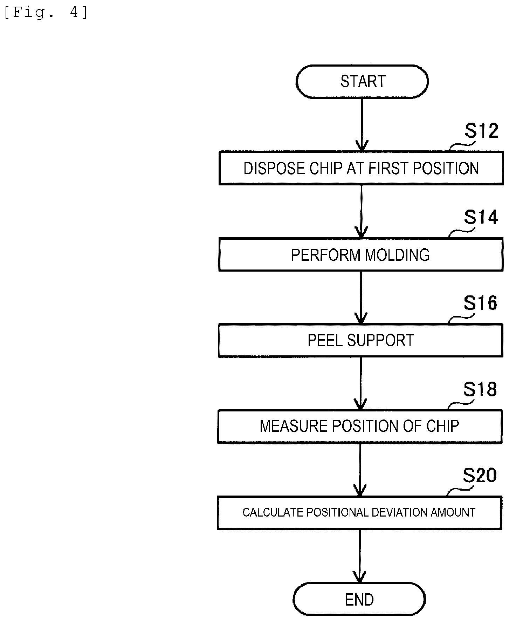

As illustrated in Fig. 4, first, chip disposition section 12 disposes chip 52 at the first position (the position on the design) on support 62 (S12). Multiple chips 52 are disposed on support 62. Accordingly, chip disposition section 12 disposes multiple chips 52 on support 62 at the first positions thereof.

Next, molding is performed by molding section 14 (S14). That is, mold body 60 including support 62, chip 52, and molding material 54 is formed. Specifically, support 62 (specifically, support 62 on which multiple chips 52 are placed) is carried from chip disposition section 12 to molding section 14. Molding section 14 disposes the mold on support 62 so as to cover multiple chips 52. Molding section 14 covers the peripheries of multiple chips 52 disposed on support 62 with molding material 54 by injecting molten molding material 54 into the mold. In this case, an external force acts on chip 52 by the flow pressure from the molten mold resin on support 62. When the flow pressure by the mold resin is larger than the adhesive force of adhesive tape 66, chip 52 moves from the position where the chip is disposed by chip disposition section 12. Which of multiple chips 52 moves, and a movement amount of chip 52 when chip 52 moves is caused by a disposition position of each chip 52, a position at which the molten resin is injected into the mold, or the like.

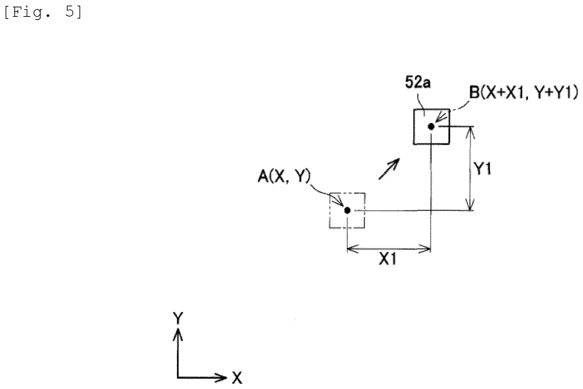

For example, an example in which chip 52a which is one of multiple chips 52 disposed on a support 62 moves will be described with reference to Fig. 5. As illustrated in Fig. 5, it is assumed that a flow pressure of a resin acts on chip 52a in a +X-direction and a +Y-direction (upper right in Fig. 5) at the time of the molding. For example, this case is a case where a molten resin is injected from a position in a -X-direction and a -Y-direction (lower left in Fig. 5) with respect to chip 52a on support 62 and the molten resin spreads in the +X-direction and the +Y-direction (upper right in Fig. 5). In this case, chip 52a disposed at first position A of chip 52a moves from first position A to position B in the +X-direction and the +Y-direction in the molding step. For example, after the molding step, chip 52a is positioned at position B (X+X1, Y+Y1) which has moved by X1 in the X-direction and +Y1 in the Y-direction from first position A (X, Y). In this case, the movement amount of chips 52 differs depending on a disposition position of chip 52 on support 62, an injection position of the resin injected to support 62, or the like. That is, the movement amounts for multiple chips 52 disposed on support 62 are different from each other.

Next, support 62 is peeled from mold body 60 by support peeling section 16(S16). As a result, the chip composite including chip 52 and molding material 54 is formed. By peeling support 62 from mold body 60, the surface of mold body 60 which abuts on support 62 is exposed. That is, in the chip composite, the surface of chip 52 on which electrode pads 53 are formed is exposed.

Next, position measurement section 18 measures the position of chip 52 in the chip composite (S18). By peeling support 62 in Step S16, in the chip composite, chip 52 is exposed. Position measurement section 18 measures the position of chip 52 by photographing the surface where chip 52 is exposed with a camera. Position measurement section 18 transmits the captured image to control section 30.

Finally, position adjustment section 32 of control section 30 calculates the positional deviation amount of chip 52 based on the image captured by position measurement section 18 (S20). Position adjustment section 32 calculates the positional deviation amount of chip 52 based on the first position of each chip 52 and the position of chip 52 which is measured (photographed) in Step S18. For example, in the example illustrated in Fig. 5, chip 52a is positioned at the position B (X+X1, Y+Y1) moved from the first position A (X, Y). From two positions A and B, position adjustment section 32 calculates the positional deviation amount of chip 52a as the +X1 in the X-direction and the +Y1 in the Y-direction in the molding step (that is, due to the flow pressure of the resin at the time of the molding). Similarly, for each of multiple chips 52, the positional deviation amount from the first position of each chip 52 is calculated based on the position of each chip 52 measurement (photographed) in Step S18 and the first position of chip 52. Thus, by executing the positional deviation amount calculation processing illustrated in Fig. 4, it is possible to accurately calculate the positional deviation amount caused by the flow pressure of the resin at the time of the molding for each chip 52.

The above-described positional deviation amount calculation processing can be executed multiple times. By calculating an average value of the positional deviation amounts calculated multiple times, it is possible to more accurately calculate the positional deviation amount of each chip.

Although the positional deviation amount of each chip 52 is calculated by the measurement in the present embodiment, configuration is not limited to this. For example, the positional deviation amount of each chip 52 may be calculated by simulation based on the disposition position of chip 52, the position at which the resin is injected into the mold, the adhesive force of adhesive tape 66, the flow pressure of the resin, or the like.

Moreover, in the present embodiment, the positions of all chips 52 disposed on support 62 after the molding are measured, but configuration is not limited to this. The positions after the molding may be measured only for some selected chips 52 of multiple chips 52, and positions after the molding of the other chips 52 may be predicted based on the measurement results of selected chips 52. For example, when it can be assumed that the positional deviation amount is linearly changed due to the flow pressure, for multiple chips 52 disposed on the same line along a flow direction, the positions after the molding may be measured only for some selected chips 52, and the positions after the molding for the other chips 52 may be calculated by interpolation or extrapolation based on the measurement results of selected chips 52.

Next, a step of manufacturing package 50 will be described. In the manufacturing step of package 50 described below, the disposition position of chip 52 is adjusted based on the positional deviation amount of chip 52 after the molding step calculated by the above-described positional deviation amount calculation processing, and package 50 is manufactured.

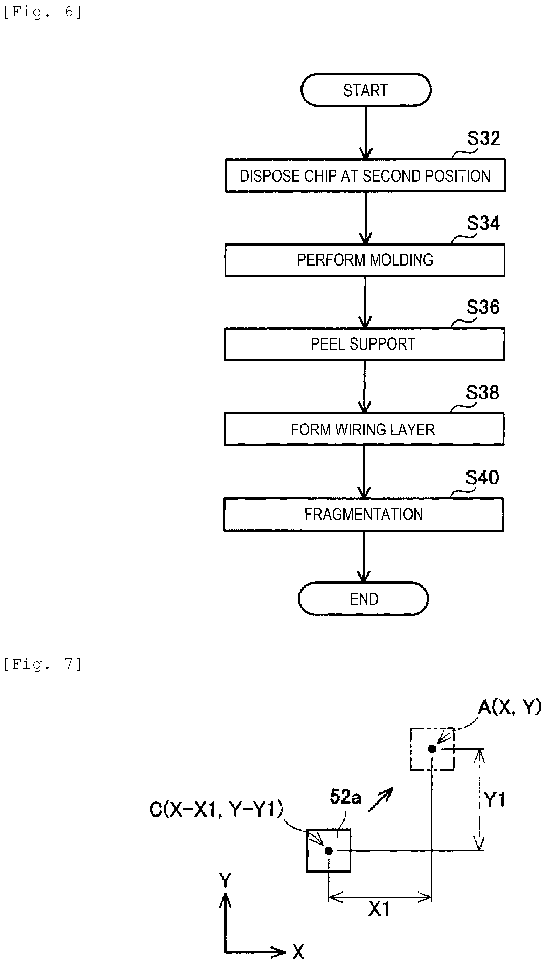

As illustrated in Fig. 6, first, chip 52 is disposed on support 62 by chip disposition section 12 (S32). In this case, chip disposition section 12 disposes the chip 52 at a position (hereinafter, this position may also be referred to as a "second position") set based on the positional deviation amount of chip 52 calculated in the above-described Step S20. The second position is set by the position adjustment section 32. Position adjustment section 32 sets the second position so that chip 52 after moving by the flow pressure of the resin at the time of the molding (Step S34 illustrated below) is positioned at the first position.

For example, in the example illustrated in Fig. 5, position adjustment section 32 calculates in Step S20 that chip 52a has moved by +X1 in the X-direction and by +Y1 in the Y-direction. That is, it can be said that chip 52a is moved by +X1 in the X-direction and by +Y1 in the Y-direction due to the flow pressure at the time of the molding. Based on this, position adjustment section 32 sets the second position of chip 52a so that chip 52a is positioned at first position A after the molding step. Specifically, as illustrated in Fig. 7, when chip 52a moves by +X1 in the X-direction and by +Y1 in the Y-direction, the position adjustment section 32 sets a position C (X-X1, Y-Y1) which is away by -X1 in the X-direction and by -Y1 in the Y-direction from a position at located at first position A, that is, from first position A (X, Y) as the second position. Similarly, the position adjustment section 32, for each of multiple chips 52 disposed on support 62, sets the second position based on the positional deviation amount calculated in Step S20. Position adjustment section 32 transmits the set information on the second position of each chip 52 to chip disposition section 12. Chip disposition section 12 disposes chips 52 at the second positions according to the received information.

Then, the molding is performed by molding section 14 (S34). At the time of the molding, chip 52 is moved by the flow pressure of the resin. In Step S32, each of multiple chips 52 is disposed at the second position set in consideration of the positional deviation amount at the time of the molding. For example, in the example illustrated in Fig. 7, in Step S32, chip 52a is disposed at second position C which is away by -X1 in the X-direction and -Y1 in the Y-direction from first position A. As described above, chip 52a moves by +X1 in the X-direction and +Y1 in the Y-direction in the molding step. Therefore, if chip 52a moves by +X1 in the X-direction and by +Y1 in the Y-direction from the disposed second position C in the molding step and the molding step is completed, chip 52a is positioned at the position moved by +X1 in the X-direction and by +Y1 in the Y-direction from second position C, that is, at first position A. In Step S32, each of multiple chips 52 is disposed at the second position of chip 52. Therefore, in the molding step, similarly to chip 52a illustrated in Fig. 7, each of multiple chips 52 moves from the second position to the first position. Thus, by disposing chip 52 at the second position set based on the positional deviation amount calculated in Step S20, it is possible to position chip 52 at the first position after the molding step.

Next, support 62 is peeled from mold body 60 by support peeling section 16 (S36). Accordingly, the chip composite is formed. In Step S34, each chip 52 in mold body 60 after the molding is positioned at the first position of chip 52. Therefore, even in the chip composite, each chip 52 is positioned at the position corresponding to the first position of mold body 60.

Next, wiring layer forming section 20 forms wiring layer 56 on the surface where chip 52 of the chip composite is exposed (S38). In the chip composite, each chip 52 is located at the position corresponding to the first position of mold body 60. Therefore, when wiring layer 56 is formed by wiring layer forming section 20, wiring layer 56 can be formed at an accurate position with respect to each chip 52.

Finally, in die-cutting section 22, die-cutting (fragmentation) is performed to obtain the structure constituted by chip 52, molding material 54, and wiring layer 56 so as to include individual chips 52 (S40). Accordingly, multiple packages 50 can be manufactured at once. Since each chip 52 is disposed at a desired position in each manufactured package 50, individual packages 50 can be accurately manufactured.

In the present embodiment, in consideration of the positional deviation amount of chip 52 which is moved by the flow pressure of the resin at the time of the molding, the position of chip 52 to be disposed on support 62 is set. Accordingly, chip 52 can be positioned at a desired position (first position) after the molding step. Therefore, wiring layer 56 can be formed at an accurate position with respect to chip 52, and package 50 can be manufactured with a high yield.

The processing of calculating the positional deviation amount of chip 52 may be performed not only before the manufacturing (manufacturing step illustrated in Fig. 6) of package 50 but also after the manufacturing of package 50. For example, after the step of peeling support 62 in Step S36 illustrated in Fig. 6, processing of measuring the position of chip 52 similar to Step S18 may be performed. In a case where the measured position of chip 52 is deviated from the first position, chip 52 may be disposed at a position where the second position is further adjusted based on the measurement result when chip 52 is disposed on support 62. Accordingly, chip 52 can be disposed at a position closer to the first position after the molding step.

Moreover, in the present embodiment, when chip 52 is disposed on support 62, chip 52 is disposed so that the surface of chip 52 on which electrode pads 53 are formed abuts on support 62, but configuration is not limited to this. For example, chip 52 may be disposed on support 62 so that the surface of chip 52 on which electrode pads 53 are not formed abuts on support 62. That is, in a state in which chip 52 is disposed above support 62, chip 52 may be disposed on support 62 so that the surface of chip 52 on which electrode pads 53 are formed becomes an upper surface. In this case, after the molding step, molding material 54 is ground until the surface where electrode pads 53 of chip 52 are formed is exposed, and thereafter, wiring layer 56 is formed on the surface of chip 52 where electrode pads 53 are exposed. Even in this configuration, by setting the position of chip 52 to be disposed on support 62 in consideration of the positional deviation amount of chip 52 which is moved by the flow pressure of the resin at the time of the molding, chip 52 after the molding step can be positioned at a desired position (first position).

The technical elements described in the present specification or the drawings exhibit technical usefulness alone or in various combinations, and are not limited to the combinations described in Claims at the time of filing. In addition, the techniques exemplified in the present specification or the drawings simultaneously achieve multiple purposes, and achieving one of the purposes itself has technical usefulness.

## Claims

1. A method of manufacturing a mold body including a support, a chip disposed at a first position preset on the support, and a molding material covering a periphery of the chip,
the method comprising:
a disposition step of disposing the chip at a second position set on the support; and
a molding step of molding the periphery of the chip disposed on the support in the disposition step with the molding material,
wherein in the molding step, the chip disposed at the second position is moved to the first position by a flow pressure of the molding material.

2. The method of manufacturing a mold body according to claim 1, further comprising:
a pre-disposition step of disposing the chip at the first position on the support before the disposition step;
a pre-molding step of molding the periphery of the chip disposed at the first position in the pre-disposition step with the molding material; and
a measurement step of measuring a position of the chip on the support after the pre-molding step,
wherein the second position is set based on a positional deviation amount between the position of the chip measured in the measurement step and the first position.

3. The method of manufacturing a mold body according to claim 1 or 2,
wherein the mold body includes the support, multiple chips disposed on the support, and the molding material covering peripheries of the multiple chips, and the first position and the second position are individually set for each of the multiple chips.

4. A method of manufacturing a package comprising:
a peeling step of peeling the support from the mold body according to any one of claims 1 to 3; and
a wiring layer forming step of forming a wiring layer connected to the chip after the peeling step.

5. A device for manufacturing a mold body including a support, a chip disposed at a first position preset on the support, and a molding material covering a periphery of the chip,
the device comprising:
a chip disposition section configured to dispose the chip on the support;
a molding section configured to mold the periphery of the chip disposed on the support with the molding material;
a position measurement section configured to measure a position of the chip on the support after molding is performed by the molding section; and
a position adjustment section configured to adjust a disposition position, at which the chip is disposed by the chip disposition section, so that the position of the chip after the molding is performed by the molding section becomes the first position, adjusting the disposition position being performed based on a positional deviation amount between a position of the chip before the molding is performed by the molding section and the position of the chip after the molding is performed by the molding section.
